# FASCICULE DE BREVET EUROPEEN

(11) **EP 2 720 986 B1**
(45) Date de publication et mention de la délivrance du brevet: **27.11.2019**
(21) Numéro de dépôt: 12738500.3
(22) Date de dépôt: 15.06.2012
(51) Int. Cl.: C03C 17/245, C03C 17/00, C23C 14/00, C23C 14/06, C23C 14/08, C23C 14/10

(54) **PROCEDE DE FABRICATION D'UN VITRAGE COMPRENANT UNE COUCHE POREUSE**
VERFAHREN ZUR HERSTELLUNG EINER VERGLASUNG MIT EINER PORÖSEN SCHICHT
PROCESS FOR MANUFACTURING GLAZING COMPRISING A POROUS LAYER

(30) Priorité: 17.06.2011 FR 1155329
(43) Date de publication de la demande: 23.04.2014
(73) Titulaire: Saint-Gobain Glass France, 92400 Courbevoie (FR)
(72) Inventeur: KHARCHENKO, Andriy, 91120 Palaiseau (FR); ROUSSEAU, Jean-Paul, 92100 Boulogne (FR); JUNG, Antje, 52355 Dueren (DE); PETERSEN, Christian Bernhard, 52064 Aachen (DE)
(74) Mandataire: Saint-Gobain Recherche
(86) Numéro de dépôt international: PCT/FR2012/051348
(87) Numéro de publication internationale: WO 2012/172266

(56) Documents cités:
- EP-A1- 1 679 291
- US-A- 6 054 206
- US-A1- 2002 164 429
- US-A1- 2004 115 954
- US-A1- 2004 235 291
- US-A1- 2005 079 201
- US-A1- 2005 136 240
- E. KOEP, M. VARELA, J. R. MORANTE: "Nanoporous films obtained by sacrificial layer pulsed laser deposition", THIN SOLID FILMS, vol. 518, 2009, pages 383-386, XP026666714, DOI: 10.1016/j.tsf.2009.07.058

## Description

L'invention concerne un procédé d'obtention d'un vitrage comprenant une couche poreuse, notamment à propriétés antireflets, ou antisalissure constituée par un matériau poreux constitué essentiellement d'un métal tel que le silicium ou le titane, d'oxygène et éventuellement, en quantité minoritaire, du carbone et de l'hydrogène. Le vitrage trouve notamment ses applications dans le domaine du bâtiment ou de l'automobile. Il trouve également son application dans les dispositifs utilisés pour le recouvrement de l'énergie lumineuse solaire, notamment dans le domaine des cellules photovoltaïques ou des collecteurs solaires, ou encore alternativement dans le domaine des vitrages autonettoyants à propriétés photocatalytiques.

Il est bien connu qu'une partie de la lumière traversant un substrat, notamment verrier, est réfléchie à la surface de celui-ci. Une telle réflexion diminue de façon sensible le rendement des systèmes photovoltaïques ou des collecteurs solaires protégés par le substrat. Dans le domaine du bâtiment ou de l'automobile, il est également recherché parfois une diminution de la réflexion lumineuse.

Le principe de dépôt d'un revêtement antireflet sur un substrat transparent, typiquement verrier est bien connu de l'art : il s'agit de disposer sur le substrat d'indice de réfraction d'environ n = 1,5, une couche ou un empilement de couches interférentielles permettant de diminuer le pourcentage de lumière R_{L} réfléchie à la surface du substrat et d'en augmenter le facteur de transmission lumineuse T_{L}.

Par l'ajustement du nombre, de la nature chimique (et donc de leur indice optique), et des épaisseurs des différentes couches successives de l'empilement, il est possible de ramener la réflexion lumineuse à des valeurs extrêmement faibles, que ce soit dans le domaine du visible (350 à 800 nm) ou dans le domaine de l'infrarouge proche (800 à 2500 nm).

Par exemple, il a déjà été décrit par la société déposante, notamment dans la demande EP 1206715 A1, des empilements antireflets comprenant une succession de couches à bas et haut indices, permettant l'obtention de vitrages à propriétés antireflets. Les différentes couches minces interférentielles constituant les empilements sont classiquement déposées par les techniques de dépôt sous vide du type pulvérisation cathodique.

Selon une autre technique, il a été également été proposé, notamment dans le brevet EP 1 181 256 B1, des revêtements antireflets constitués par une unique couche d'un matériau essentiellement constitué d'oxyde de silicium poreux. Selon cet art antérieur, la mise en œuvre d'un tel matériau poreux, dont l'épaisseur de la couche est ajustée en fonction de la longueur du rayonnement incident, permet de diminuer l'indice de réfraction jusqu'à des valeurs voisines de 1,22, et par suite d'obtenir une réflexion presque nulle à la surface d'un substrat de verre d'indice 1,5, cette couche gardant l'essentiel de sa porosité lors d'un frittage d'au moins 630°C. Le procédé de synthèse d'une telle couche comprend l'étape essentielle de la condensation hydrolytique par voie sol-gel d'un composé du silicium du type RSiX₄.

La demande de brevet EP 1 676 291 décrit, toujours pour l'obtention d'une couche en oxyde de silicium poreux d'indice de réfraction inférieur à celui du verre, des procédés comprenant selon une première étape le dépôt sur le substrat, en phase vapeur (CVD ou Chemical Vapor Déposition, selon le terme anglais) ou de dépôt physique en phase vapeur (ou PVD de l'anglais Physical Vapor Déposition), d'une couche primaire d'un matériau contenant de l'oxygène, du silicium, du carbone et de l'hydrogène. Selon une seconde étape, la couche primaire est soumise à un traitement thermique (chauffage) permettant l'obtention, par élimination d'au moins une partie du carbone et de l'hydrogène présent dans la couche primaire, d'une couche poreuse, présentant une porosité de l'ordre du nanomètre.

Selon le procédé CVD, un gaz contenant le réactif est amené sur le substrat, en présence d'apport de chaleur issu le plus souvent du substrat porté à température, et réagit alors à la surface de celui pour y former le produit réactionnel.

Les procédés PVD englobent de façon différente des procédés de revêtement sous vide poussé, dans lesquels le matériau à déposer ou ses précurseurs sont introduits en phase gazeuse par des méthodes physiques comme un plasma ou un faisceau d'ion, pour être ensuite déposé sur les substrats. Parmi ces procédés, la pulvérisation cathodique magnétron (ou sputtering selon le terme anglais) est la plus utilisée pour le dépôt de couches minces sur un substrat : selon ce procédé, dans une chambre à vide sous pression constante d'un gaz générateur de plasma, par exemple l'argon, on génère un plasma entre deux électrodes, au moyen d'une tension continue ou à haute fréquence. Les ions de gaz positifs produits dans le plasma sont accélérés et viennent frapper un solide disposé sur la cathode, appelée cible. Les atomes arrachés du solide par l'impact des ions d'argon diffusent dans le plasma, et se déposent sur le substrat disposé sur l'anode. Les atomes du solide de la cathode peuvent également réagir avec des espèces supplémentaires introduites dans le plasma. On parle alors de pulvérisation réactive. La couche finale est ainsi constituée d'un matériau résultant d'une réaction chimique entre les éléments arrachés de la cible et le gaz contenu dans le plasma.

Tout particulièrement, la demande EP 1 676 291 décrit comme mode possible un tel procédé PVD dans lequel comprenant la pulvérisation d'une cible en silicium métallique ou en en silice est utilisée, dans une atmosphère réactive comprenant un mélange d'alcènes ou d'un mélange alcène/oxygène, dans un gaz plasma d'argon ou d'un mélange argon/oxygène. Une source supplémentaire de silicium peut être introduite dans le gaz plasma, afin d'augmenter la vitesse de dépôt de la couche sur le substrat.

Une telle réalisation pose cependant des problèmes sur la couche finalement obtenue : si on choisit d'utiliser une cible en silicium pur, les essais menés ont montrés qu'il n'était pas possible d'obtenir de couches à bas indice optique, par référence à l'indice optique du matériau non poreux. Par matériau poreux à « bas » indice optique, on entend au sens de la présente invention un matériau dont la porosité entraîne l'abaissement dudit indice d'au moins 3%, 5% ou même 10% par rapport à celui connu du matériau non poreux. On entend par indice optique au sens de la présente invention l'indice optique (de réfraction) mesuré à 550 nm.

La publication E. Koep et al. : « Nanoporous films obtained by sacrificial layer pulsed laser déposition », Thin Film Solid, vol. 518, 2009, p383-386 décrit un procédé de dépôt dans lequel on utilise une cible composite de manganate de lanthane et de strontium avec du carbone.

De même, l'utilisation d'une cible en oxyde de silicium est problématique car le matériau n'étant pas conducteur, il constitue une cathode de très mauvaise qualité, entraînant des vitesses de dépôt très faibles et la présence d'arcs électriques dans l'installation.

En outre, quelque soit la cible utilisée (oxyde de silicium ou silicium métallique), une partie nécessairement importante du matériau déposé est du dioxyde de silicium dense dont l'indice de réfraction est élevé (1,47). De ce fait il n'apparaît pas possible selon de telles techniques de fabrication d'obtenir au final une couche poreuse dans sa totalité, et par suite les plus basses valeurs théoriquement possibles de l'indice de réfraction.

Selon un autre avantage, dans le cas d'une couche unique déposée sur un substrat verrier, il est utile de disposer de matériaux faciles et peu couteux à déposer, dont l'indice de réfraction est inférieur à celui du substrat verrier, de manière à limiter la réflexion à la surface du substrat. Alternativement, dans le cas d'un empilement de couches à fonction antireflet, la mise à disposition dans l'empilement d'au moins une couche poreuse obtenue selon l'invention et d'indice de réfraction ajustable, c'est-à-dire en particulier dont l'indice peut être inférieure de plusieurs pourcents à celui du matériau non poreux la constituant, permet l'obtention de degrés de liberté supplémentaires pour ajuster l'effet antireflet.

Alternativement, il peut être également utile d'obtenir des revêtements externes présentant une autre fonctionnalité que l'effet antireflet. En particulier, la société déposante a découvert que le procédé objet de l'invention permet également l'obtention de couches poreuses comprenant au moins du titane comme élément métallique, de l'oxygène et éventuellement du carbone et qui présentent des propriétés photocatalytiques, au sens décrit par exemple dans le brevet EP 850 204 B1.

De manière connue, une couche photocatalytique à base d'oxyde de titane constituée d'oxyde de titane peut être obtenue, notamment cristallisé sous forme anatase, qui est la forme la plus active. Un mélange de phases anatase et rutile est également concevable. L'obtention d'une couche poreuse selon l'invention présente en outre l'intérêt d'augmenter la surface de contact entre les salissures se déposant sur la surface du vitrage et les particules photocatalytiques de TiO₂.

L'oxyde de titane peut être pur ou dopé, par exemple par des métaux de transition (notamment W, Mo, V, Nb), des ions lanthanides ou des métaux nobles (tels que par exemple platine, palladium) ou encore du fluor. Ces différentes formes de dopage permettent soit d'augmenter l'activité photocatalytique du matériau, soit de décaler le gap de l'oxyde de titane vers des longueurs d'onde proches du domaine du visible ou comprises dans ce domaine. De préférence, la couche photocatalytique à base d'oxyde de titane ne contient pas d'atomes d'azote, car cela contribue à diminuer la transmission optique de la couche.

La couche à base d'oxyde de titane est normalement la dernière couche d'un l'empilement déposé sur le substrat, autrement dit la couche de l'empilement la plus éloignée du substrat. Il importe en effet que la couche photocatalytique soit en contact avec l'atmosphère et ses polluants. Il est toutefois possible de déposer sur la couche photocatalytique une très fine couche, généralement discontinue ou poreuse.

Selon des techniques déjà décrites, différentes couches peuvent être déposées, cumulativement ou alternativement, sous la couche à base d'oxyde de titane :
- une ou plusieurs couches faisant office de barrière à la migration des ions alcalins provenant du substrat. De telles couches peuvent être déposées par CVD avant la couche photocatalytique. Elles sont de préférence à base de ou constituées par un oxyde, un nitrure, un oxynitrure ou un oxycarbure de l'un au moins des éléments suivants : Si, Al, Sn, Zn, Zr. Parmi ces matériaux, la silice ou l'oxycarbure de silicium sont préférés de par leur facilité de dépôt par la technique CVD.
- une ou plusieurs couches à faible émissivité, telles que des couches en oxyde d'étain dopé au fluor ou à l'antimoine. De telles couches permettent de limiter la condensation (buée et/ou givre) sur la surface des vitrages multiples, en particulier lorsqu'ils sont inclinés (par exemple lorsqu'ils sont intégrés à des toitures ou des vérandas). La présence d'une couche bas-émissive en face 1 permet de limiter les échanges de chaleur avec l'extérieur pendant la nuit, et donc de maintenir une température de surface du verre supérieure au point de rosée. L'apparition de buée ou de givre est donc fortement atténuée voire totalement supprimée. La couche photocatalytique peut être déposée directement sur la couche d'oxyde d'étain dopé. Ce dernier impose d'habitude la forme rutile, moins active, mais la cristallisation en phase gazeuse obtenue par le procédé selon l'invention permet de pallier cet inconvénient. Un avantage supplémentaire du procédé selon l'invention dans ce cas est donc de permettre le dépôt de couches dans lesquelles l'oxyde de titane est cristallisé sous la forme anatase (la plus active) et déposé directement sur une couche d'oxyde d'étain dopé.

La présente invention, dans sa forme la plus générale, propose un procédé de fabrication d'un vitrage comprenant un substrat, en particulier verrier, muni d'un revêtement comprenant au moins une couche poreuse, notamment dont l'indice de réfraction en est ainsi diminuée, comprenant les étapes suivantes :
- dépôt sur le substrat, par un procédé de dépôt physique en phase vapeur PVD dans une enceinte sous vide, d'un revêtement comprenant une couche d'un matériau comprenant au moins un élément choisi parmi Si, Ti, Sn, Al, Zr, In, Zn, Nb, W, Ta, Bi, en particulier Si ou Ti, ou le mélange d'au moins deux de ces éléments, de l'oxygène, du carbone, ladite couche comprenant en outre éventuellement de l'hydrogène, ledit dépôt étant réalisé sur le substrat défilant dans ladite enceinte par la pulvérisation cathodique d'une cible en carbone, dans une atmosphère d'un plasma réactif de préférence oxydant comprenant au moins un précurseur du ou des éléments,
- traitement thermique de la couche ainsi déposée, dans des conditions permettant l'élimination d'au moins une partie du carbone et l'obtention de ladite couche poreuse.

Par indice de réfraction diminué, on entend que l'indice de réfraction du matériau poreux constituant la couche est inférieur d'au moins 3% et de préférence d'au moins 5% et de manière très préférée d'au moins 10% par rapport à l'indice de réfraction du même matériau non poreux.

Par précurseur du ou des éléments, on entend tout composé pouvant être vaporisé dans l'atmosphère du plasma réactif et contenant le ou lesdits éléments.

Par traitement thermique, on entend au sens de la présente invention tout procédé permettant l'élévation locale de la température dans la couche jusqu'à l'élimination d'au moins une partie du carbone présent initialement dans ladite couche.

Sans que cela puisse être considéré comme une règle générale, les essais de porosimétrie effectués par la société déposante ont montré que la taille moyenne des pores dans le matériau ainsi obtenu est inférieure à 10 nm, voire inférieure à 5 nm dans la couche poreuse déposée par les techniques selon l'invention.

Le procédé selon l'invention peut être avantageusement mis en œuvre selon l'un des modes réalisations préféré qui suit, étant bien entendu que ces modes peuvent être combinés entre eux, le cas échéant :
- La puissance appliquée sur la cathode de carbone est comprise entre 0,5 et 20 kW/m, notamment entre 0,5 et 5 kW/m. La polarisation appliquée sur la cathode peut être en courant continu ou en courant alternatif.
- La pression totale des gaz dans l'enceinte sous vide est comprise entre 0,1 et 2 Pa.
- La pression partielle du ou des précurseurs dans l'enceinte est comprise entre 0,05 et 1,5 Pa.
- Selon un premier mode, l'atmosphère de plasma réactif est constituée essentiellement d'un gaz neutre tel que l'argon et au moins un des précurseurs comprend de l'oxygène.
- Selon un mode alternatif, l'atmosphère du plasma réactif comprend le mélange d'un gaz neutre tel que l'argon et d'un gaz oxydant tel que l'oxygène.
- Selon un autre mode alternatif, l'atmosphère du plasma réactif est constituée essentiellement de précurseurs dont au moins l'un contient de l'oxygène.
- L'étape de traitement thermique est mise en œuvre dans des conditions permettant l'élimination d'au moins une partie du carbone et de l'hydrogène, jusqu'à l'obtention d'une couche poreuse dans lequel le taux de carbone résiduel est inférieur à 15% atomique, de préférence est inférieur à 10% atomique et de manière très préférée est inférieur à 5 % atomique.
- Le traitement thermique de la couche est opéré entre 300 et 800°C, pendant une durée inférieure à 1 heure.
- Le traitement thermique est opéré selon les modalités définies dans la demande EP 2 118 031.
- On utilise comme élément le silicium ou un mélange d'éléments incluant majoritairement le silicium. Par « incluant majoritairement », on entend plus de 50% de la somme desdits éléments présents et de préférence plus de 80% ou même plus de 90% atomique de la somme desdits éléments présents.
- On utilise comme élément le silicium ou un mélange d'éléments incluant majoritairement le silicium et le traitement thermique est mis en œuvre dans des conditions permettant l'élimination d'au moins une partie du carbone et de l'hydrogène, jusqu'à l'obtention d'une couche poreuse d'indice de réfraction inférieure à 1,42, de préférence inférieure à 1,40, ou même inférieur à 1,35.
- On utilise comme élément le silicium ou un mélange d'éléments incluant majoritairement le silicium et l'épaisseur de la couche poreuse, après traitement thermique est comprise entre 30 et 150 nm, de préférence entre 50 et 120 nm.
- On utilise comme élément le titane ou un mélange d'éléments incluant majoritairement le titane. Par incluant majoritairement, on entend plus de 50% de la somme desdits éléments présents et de préférence plus de 80% ou même plus de 90% atomique de la somme desdits éléments présents.
- On utilise comme élément le titane ou un mélange d'éléments incluant majoritairement le titane et le traitement thermique est mis en œuvre dans des conditions permettant l'élimination d'au moins une partie du carbone et de l'hydrogène, jusqu'à l'obtention d'une couche poreuse

d'indice de réfraction inférieure à 2,30, de préférence inférieure à 2,20.
- On utilise comme élément le titane ou un mélange d'éléments incluant majoritairement le titane et l'épaisseur de la couche poreuse, après traitement thermique est comprise entre 5 et 120 nm, et notamment entre 5 et 25 nm ou entre 80 et 120 nm.
- On utilise comme élément le titane ou un mélange d'éléments incluant majoritairement le titane et la couche poreuse présente une activité photocatalytique du type antisalissure.

De manière générale il est possible selon l'invention d'utiliser comme précurseur tout composé organométallique comprenant au moins un atome du ou des éléments sélectionnés dans la liste précédente et au moins un groupement choisi parmi les alkyls (en particulier les méthyl et les éthyls), le chlore, l'oxygène, l'hydrogène, les alcoxys, les cycles aromatiques (phenyls), les alkényl, les alkynyls.

En particulier selon certains modes de réalisations particuliers de l'invention:
- On utilise comme élément le silicium ou un mélange d'éléments incluant majoritairement le silicium et le ou les précurseurs sont choisis parmi les organométalliques de silicium, en particulier choisi(s) parmi les siloxanes, par exemple l'hexamethyldisiloxane (HMDSO) ou le TDMSO (tétraméthyldisiloxane).
- On utilise comme élément le silicium ou un mélange d'éléments incluant majoritairement le silicium et le ou les précurseurs sont choisis parmi les alkyl silanes et les alcoolates de silicium, par exemple le diétoxymethylsilane (DEMS), Si(OC₂H₅)₄ (TEOS), Si(OCH₃)₄ (TMOS), (Si(CH₃)₃)₂ (HMDS), Si(CH₃)₄ (TMS), (SiO(CH₃)₂)₄, (SiH (CH₃)₂)₂.
- On utilise comme élément le silicium ou un mélange d'éléments incluant majoritairement le silicium et le ou les précurseurs sont choisis parmi les hydrures de silicium, en particulier SiH₄ ou Si₂H₆.
- On utilise comme élément le silicium ou un mélange d'éléments incluant majoritairement le silicium et le ou les précurseurs sont choisis parmi les chlorures de silicium, en particulier SiCl₄, CH₃SiCl₃, (CH₃)₂SiCl₂.

Selon d'autres modes de réalisations particuliers de l'invention:
- On utilise comme élément le titane ou un mélange d'éléments incluant majoritairement le titane et le ou les précurseurs du titane sont choisis parmi les organo-métalliques de titane ou les alkyltitanes et/ou les alcoolates de titane, en particulier tétraisopropylate de Ti, le di-iso-propoxy di-acétylacétonate de titane et le tétra-octylène glycolate de titane, l'acétylacétonate de titane, le méthylacétoacétate de titane, l'éthylacétoacétate de titane le chlorure de titane TiCl₄.

L'invention se rapporte également au vitrage susceptible d'être obtenu selon le procédé tel que précédemment exposé.

En particulier, l'invention concerne un vitrage comprenant un revêtement constitué par au moins une couche d'un matériau poreux constitué essentiellement de silicium, d'oxygène et éventuellement de carbone et de l'hydrogène, d'indice de réfraction inférieure à 1,40, susceptible d'être obtenu par un procédé tel que décrit précédemment.

L'invention concerne en outre un vitrage comprenant un revêtement constitué par au moins une couche d'un matériau poreux constitué essentiellement de titane, d'oxygène et éventuellement de carbone et de l'hydrogène, présentant des propriétés photocatalytiques et susceptible d'être obtenu par un procédé tel que décrit précédemment.

L'invention et ses avantages seront mieux compris à la lecture des exemples non limitatifs qui suivent.

### Exemples :

Différentes couches selon l'invention ont été déposées sur des substrats en verre sodo-calcique d'une épaisseur de 4 mm, commercialisé sous la référence PLANILUX® par la société déposante, dans des enceintes de pulvérisation cathodique assistée par champ magnétique (magnétron). Avant chaque dépôt un vide résiduel est effectué dans l'enceinte, jusqu'à atteindre une valeur de 0,5 millipascals (mPa), selon les techniques bien connues dans le domaine. Une cible en carbone est installée au niveau de la cathode selon l'invention. Différents mélanges de gaz comprenant l'organométallique de silicium (HMDSO : Hexamethyldisiloxane) source de silicium, en mélange éventuellement avec l'argon ou un mélange argon/oxygène comme gaz porteurs sont introduits dans l'enceinte, jusqu'à atteindre une pression totale des gaz variant entre 2 et 10 mTorrs (0,27 à 1,33 Pascals).

Les débits des gaz Ar et O₂ sont donnés dans le tableau 1 qui suit. Le débit du précurseur est ajusté de manière à ce que sa pression partielle dans l'enceinte soit maintenue entre 0,05 et 1 Pascal.

Le plasma est allumé et une puissance de 520 W/m à 1110 W/m est appliquée sur la cathode en Carbone, avec une fréquence de pulsation de 50 kHz et 10 µs de durée des pulses inversés.

Le ruban de verre défile en face de la cathode. Une couche du matériau produit par la réaction des atomes de carbone pulvérisés de la cible ave le HDMSO dans le plasma réactif est déposé finalement sur le substrat, dont la vitesse est ajustée pour recueillir une épaisseur de couche de quelques dizaines de nanomètres.

Le substrat ainsi revêtu est ensuite soumis à un traitement thermique consistant en un chauffage à 620°C pendant 10 minutes.

Le tableau 1 qui suit résume les données expérimentales pour chacun des vitrages réalisés selon l'invention :

**Tableau 1**

| Exemple | débit (sccm) | | Pression totale (mTorr) | Puissance cathode Watt/m | Fréquence (kHz) | Vitesse Substrat (mm/s) |
|---|---|---|---|---|---|---|
| | O₂ | Ar | | | | |
| 1 | 0 | 50 | 5 | 520 | 50 | 1 |
| 2 | 0 | 50 | 2 | 520 | 50 | 0,5 |
| 3 | 0 | 50 | 10 | 550 | 50 | 1 |
| 4 | 0 | 20 | 5 | 1110 | 50 | 1 |
| 5 | 0 | 20 | 5 | 1110 | 50 | 1 |
| 6 | 5 | 20 | 5 | 1110 | 50 | 1 |
| 7 | 5 | 2 | 3 | 1110 | 50 | 1 |
| 8 | 0 | 0 | 5,5 | 1110 | 50 | 1 |
| 9 | 0 | 0 | 3 | 1110 | 50 | 1 |
| 10 | 0 | 0 | 5,5 | 1110 | 50 | 1,6 |
| 11 | 5 | 20 | 5 | 1110 | 50 | 1,3 |
| 12 | 0 | 20 | 5 | 1110 | 50 | 1,3 |
| 13 | 0 | 50 | 2 | 520 | 50 | 0,25 |

Pour tous les exemples, on a mesuré l'indice de réfraction de la couche déposée sur le substrat avant et après l'étape de traitement thermique à 620°C. Les indices de réfraction sont mesurés selon la présente invention à 550 nm, selon la norme DIN 67507.

Les résultats sont donnés dans le tableau 2 ci dessous :

**Tableau 2**

| Exemple | Indice n avant recuit | Indice n après recuit | Epaisseur couche avant recuit (nm) | Epaisseur couche après recuit (nm) |
|---|---|---|---|---|
| 1 | 1,47 | 1,26 | 54 | 45 |
| 2 | 1,50 | 1,28 | 58 | 51 |
| 3 | - | 1,34 | - | 40 |
| 4 | 1,59 | 1,31 | 61 | 47 |
| 5 | 1,53 | 1,32 | 151 | 123 |
| 6 | 1,44 | 1,31 | 119 | 91 |
| 7 | 1,46 | 1,33 | 103 | 82 |
| 8 | - | 1,32 | - | 100 |
| 9 | - | 1,34 | - | 52 |
| 10 | 1,49 | 1,32 | 138 | 77 |
| 11 | 1,48 | 1,37 | 140 | 101 |
| 12 | 1,54 | 1,33 | 126 | 105 |
| 13 | 1,56 | 1,36 | 109 | 92 |

Les résultats reportés dans le tableau 2 montrent de façon étonnante que l'utilisation d'un procédé par les techniques de pulvérisation cathodique selon l'invention, dans lequel, de façon tout à fait nouvelle, une cible en carbone est utilisée en combinaison avec un plasma contenant un organométallique de silicium, permet l'obtention de couches essentiellement en silice poreuse de faible indice de réfraction, c'est-à-dire d'indice de réfraction inférieur à 1,42, voir inférieur à 1,40 ou même inférieur à 1,35.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

## Revendications

1. Procédé de fabrication d'un vitrage comprenant un substrat, en particulier verrier, muni d'un revêtement comprenant au moins une couche constituée par un matériau poreux, notamment dont l'indice de réfraction en est ainsi diminué, comprenant les étapes suivantes :
- dépôt sur le substrat, par un procédé de dépôt physique en phase vapeur PVD dans une enceinte sous vide, d'un revêtement comprenant une couche d'un matériau comprenant au moins un élément choisi parmi Si, Ti, Sn, Al, Zr, In ou un mélange d'au moins deux de ces éléments, de l'oxygène, du carbone, ladite couche comprenant en outre éventuellement de l'hydrogène,
- traitement thermique de la couche ainsi déposée, dans des conditions permettant l'élimination d'au moins une partie du carbone et l'obtention de ladite couche du matériau poreux,
ledit procédé **se caractérisant en ce que** ledit dépôt est réalisé, sur le substrat défilant dans ladite enceinte, par la pulvérisation cathodique d'une cible en carbone, dans une atmosphère d'un plasma réactif de préférence oxydant comprenant au moins un précurseur du ou des éléments.

2. Procédé selon la revendication 1, dans lequel la puissance appliquée sur la cathode est comprise entre 0,5 et 20 KW/m.

3. Procédé selon l'une des revendications précédentes, dans lequel la pression totale des gaz dans l'enceinte sous vide est comprise entre 0,1 et 2 Pascals.

4. Procédé selon l'une des revendications précédentes, dans lequel la pression partielle du ou des précurseurs dans l'enceinte est comprise entre 0,05 et 1,5 Pa.

5. Procédé selon l'une des revendications précédentes, dans lequel l'atmosphère de plasma réactif est constituée essentiellement d'un gaz neutre tel que l'argon et au moins un des précurseurs comprend de l'oxygène.

6. Procédé selon l'une des revendications 1 à 4, dans lequel l'atmosphère du plasma réactif comprend le mélange d'un gaz neutre tel que l'argon et d'un gaz oxydant tel que l'oxygène.

7. Procédé selon l'une des revendications 1 à 4, dans lequel l'atmosphère du plasma réactif est constituée essentiellement de précurseurs dont au moins l'un contient de l'oxygène.

8. Procédé selon l'une des revendications précédentes dans lequel l'étape de traitement thermique est mise en œuvre dans des conditions permettant l'élimination d'au moins une partie du carbone, jusqu'à l'obtention d'une couche poreuse dans lequel le taux de carbone est inférieur à 15% atomique, de préférence inférieure à 10% atomique et de manière préférée inférieure à 5% atomique.

9. Procédé selon l'une des revendications précédentes dans lequel on utilise comme élément le silicium ou un mélange d'éléments incluant majoritairement le silicium, le traitement thermique étant mis en œuvre dans des conditions permettant l'élimination d'au moins une partie du carbone et de l'hydrogène, jusqu'à l'obtention d'une couche poreuse d'indice de réfraction inférieure à 1,42, de préférence inférieure à 1,40, ou même inférieur à 1,35.

10. Procédé selon la revendication 9 dans lequel le ou les précurseurs sont choisis parmi les organométalliques de silicium, en particulier choisi(s) parmi les siloxanes, par exemple l'hexamethyldisiloxane (HMDSO), ou le TDMSO (tétraméthyldisiloxane), les alkylsilanes, par exemple le diétoxymethylsilane (DEMS), Si(CH₃)₃)₂ (HMDS), Si(CH₃)₄ (TMS), (SiO(CH₃)₂)₄, (SiH(CH₃)₂)₂, les alcoolates de silicium, par exemple Si(OC₂H₅)₄ (TEOS), Si(OCH₃)₄ (TMOS), ou encore les hydrures de silicium, en particulier SiH₄ ou Si₂H₆, ou les chlorures de silicium, en particulier SiCl₄, CH₃SiCl₃, (CH₃)₂SiCl₂.

11. Procédé selon l'une des revendications 1 à 8 dans lequel on utilise comme élément le titane ou un mélange d'éléments incluant majoritairement le titane.

12. procède selon la revendication 11 dans lequel le traitement thermique est mis en œuvre dans des conditions permettant l'élimination d'au moins une partie du carbone et de l'hydrogène, jusqu'à l'obtention d'une couche poreuse d'indice de réfraction inférieure à 2,30, de préférence inférieure à 2,20.

13. Procédé selon l'une des revendications 11 ou 12 dans lequel le ou les précurseurs du titane sont choisis parmi les organo-métalliques de titane ou les alkyl titanes et/ou les alcoolates de titane, en particulier le tétraisopropylate de Ti, le di-iso-propoxy di-acétylacétonate de titane et le tétra-octylène glycolate de titane, l'acétylacétonate de titane, le méthylacétoacétate de titane, l'éthylacétoacétate de titane.

14. Vitrage comprenant un revêtement constitué par au moins une couche d'un matériau poreux susceptible d'être obtenu par l'une des revendications 1 à 13.

15. Vitrage comprenant un revêtement constitué par au moins une couche d'un matériau poreux constitué essentiellement de silicium, d'oxygène et éventuellement de carbone et d'hydrogène résiduels, d'indice de réfraction inférieure à 1,40, susceptible d'être obtenu par un procédé selon l'une des revendications 9 ou 10.

16. Vitrage comprenant un revêtement constitué par au moins une couche d'un matériau poreux constitué essentiellement de titane, d'oxygène et éventuellement de carbone et d'hydrogène résiduels, susceptible d'être obtenu par un procédé selon l'une des revendications 11 à 13.

## Patentansprüche

1. Verfahren zur Herstellung einer Verglasung, umfassend ein Substrat, insbesondere ein Glassubstrat, das mit einer Beschichtung versehen ist, die mindestens eine Schicht umfasst, die aus einem porösen Material besteht, insbesondere dessen Brechungsindex somit verringert ist, umfassend die folgenden Schritte:
- Ablagern auf dem Substrat, mittels eines physikalischen Aufdampfverfahrens PVD in einer Vakuumkammer, einer Beschichtung, umfassend eine Schicht aus einem Material, das mindestens ein Element umfasst, das aus Si, Ti, Sn, Al, Zr, In oder einem Gemisch von mindestens zwei dieser Elemente, von Sauerstoff, von Kohlenstoff ausgewählt ist, wobei die Schicht gegebenenfalls ferner Wasserstoff umfasst,
- Wärmebehandeln der so abgelagerten Schicht unter Bedingungen, die das Entfernen mindestens eines Teils des Kohlenstoffs und den Erhalt der Schicht des porösem Materials ermöglichen,
wobei das Verfahren **dadurch gekennzeichnet ist, dass** die Ablagerung auf dem sich in der Kammer bewegenden Substrat durch Sputtern eines Kohlenstofftargets in einer Atmosphäre eines reaktiven, vorzugsweise oxidierenden Plasmas durchgeführt wird, das mindestens eine Vorstufe des oder der Elemente umfasst.

2. Verfahren nach Anspruch 1, wobei die an die Kathode angelegte Leistung zwischen 0,5 und 20 kW/m liegt.

3. Verfahren nach einem der vorhergehenden Ansprüche, wobei der Gesamtdruck der Gase in der Vakuumkammer zwischen 0,1 und 2 Pascal liegt.

4. Verfahren nach einem der vorhergehenden Ansprüche, wobei der Partialdruck des oder der Vorstufen in der Kammer zwischen 0,05 und 1,5 Pa liegt.

5. Verfahren nach einem der vorhergehenden Ansprüche, wobei die reaktive Plasmaatmosphäre im Wesentlichen aus einem neutralen Gas wie Argon besteht und mindestens eine der Vorstufen Sauerstoff umfasst.

6. Verfahren nach einem der Ansprüche 1 bis 4, wobei die Atmosphäre des reaktiven Plasmas das Gemisch eines neutralen Gases wie Argon und eines oxidierenden Gases wie Sauerstoff umfasst.

7. Verfahren nach einem der Ansprüche 1 bis 4, wobei die Atmosphäre des reaktiven Plasmas im Wesentlichen aus Vorstufen besteht, von denen mindestens eine Sauerstoff enthält.

8. Verfahren nach einem der vorhergehenden Ansprüche, wobei der Wärmebehandlungsschritt unter Bedingungen durchgeführt wird, die das Entfernen mindestens eines Teils des Kohlenstoffs ermöglichen, bis eine poröse Schicht erhalten wird, in der der Kohlenstoffgehalt kleiner als 15 Atom-%, vorzugsweise kleiner als 10 Atom-% und in bevorzugter Weise kleiner als 5 Atom-% beträgt.

9. Verfahren nach einem der vorhergehenden Ansprüche, wobei als Element Silicium oder ein Gemisch von mehrheitlich Silicium enthaltenden Elementen verwendet wird, wobei die Wärmebehandlung unter Bedingungen durchgeführt wird, die das Entfernen von mindestens einem Teil des Kohlenstoffs und des Wasserstoffs ermöglichen, bis eine poröse Schicht mit einem Brechungsindex von kleiner als 1,42, vorzugsweise kleiner als 1,40 oder sogar kleiner als 1,35 erhalten wird.

10. Verfahren nach Anspruch 9, wobei der oder die Vorstufen aus den Siliciumorganometallen ausgewählt sind, insbesondere ausgewählt aus den Siloxanen, beispielsweise dem Hexamethyldisiloxan (HMDSO) oder dem TDMSO (Tetramethyldisiloxan), den Alkylsilanen, beispielsweise dem Dietoxymethylsilan (DEMS), Si(CH₃)₃)₂ (HMDS), Si(CH₃)₄ (TMS), (SiO(CH₃)₂)₄, (SiH(CH₃)₂)₂, den Siliciumalkoholaten, beispielsweise Si(OC₂H₅)₄ (TEOS), Si(OCH₃)₄ (TMOS) oder auch den Siliciumhydriden, insbesondere SiH₄ oder Si₂H₆, oder den Siliciumchloriden, insbesondere SiCl₄, CH₃SiCl₃, (CH₃)₂SiCl₂.

11. Verfahren nach einem der Ansprüche 1 bis 8, wobei als Element Titan oder ein Elementegemisch verwendet wird, das mehrheitlich Titan einschließt.

12. Verfahren nach Anspruch 11, wobei die Wärmebehandlung unter Bedingungen durchgeführt wird, die das Entfernen mindestens eines Teils des Kohlenstoffs und des Wasserstoffs bis zum Erhalt einer porösen Schicht mit einem Brechungsindex kleiner als 2,30, vorzugsweise kleiner als 2,20 ermöglicht.

13. Verfahren nach einem der Ansprüche 11 oder 12, wobei die Titanvorstufe(n) aus den Titanorganometallen oder den Titanalkylen und/oder den Titanalkoholaten, insbesondere dem Ti-Tetraisopropylat, Diisopropoxy-Titandiacetylacetonat und dem Titantetraoctylenglykolat, dem Titanacetylacetonat, dem Titanmethylacetoacetat, dem Titanethylacetoacetat ausgewählt sind.

14. Verglasung, umfassend eine Beschichtung, bestehend aus mindestens einer Schicht eines porösen Materials, erhältlich nach einem der Ansprüche 1 bis 13.

15. Verglasung, umfassend eine Beschichtung, bestehend aus mindestens einer Schicht eines porösen Materials, bestehend im Wesentlichen aus Silicium, Sauerstoff und gegebenenfalls Restkohlenstoff und -wasserstoff mit einem Brechungsindex kleiner als 1,40, erhältlich durch ein Verfahren nach einem der Ansprüche 9 oder 10.

16. Verglasung, umfassend eineBeschichtung, bestehend aus mindestens einer Schicht eines porösen Materials, bestehend im Wesentlichen aus Titan, Sauerstoff und gegebenenfalls Restkohlenstoff und -wasserstoff, erhältlich durch ein Verfahren nach einem der Ansprüche 11 bis 13.

## Claims

1. A process for manufacturing glazing comprising a substrate, in particular a glass substrate, provided with a coating comprising at least one layer consisting of a porous material, in particular for which the refractive index is thus reduced thereby, comprising the following steps:
- depositing on the substrate, via a physical vapor deposition (PVD) process in a vacuum chamber, a coating comprising a layer of a material comprising at least one element selected from Si, Ti, Sn, Al, Zr, In or a mixture of at least two of these elements, oxygen and carbon, said layer in addition optionally comprising hydrogen,
- heat treatment of the layer thus deposited, under conditions that enable at least one portion of the carbon to be removed and said layer of porous material to be obtained,
said process being **characterized in that** said deposition is carried out, on the substrate passing through said chamber, by the sputtering of a carbon target, under a reactive, preferably oxidizing, plasma atmosphere comprising at least one precursor of the element or elements.

2. The process as claimed in claim 1, wherein the power applied to the cathode is between 0.5 and 20 kW/m.

3. The process as claimed in either of the preceding claims, wherein the total pressure of the gases in the vacuum chamber is between 0.1 and 2 Pa.

4. The process as claimed in one of the preceding claims, wherein the partial pressure of the precursor or precursors in the chamber is between 0.05 and 1.5 Pa.

5. The process as claimed in one of the preceding claims, wherein the reactive plasma atmosphere essentially consists of a neutral gas such as argon and at least one of the precursors comprises oxygen.

6. The process as claimed in one of claims 1 to 4, wherein the atmosphere of the reactive plasma comprises the mixture of a neutral gas such as argon and an oxidizing gas such as oxygen.

7. The process as claimed in one of claims 1 to 4, wherein the atmosphere of the reactive plasma essentially consists of precursors, at least one of which contains oxygen.

8. The process as claimed in one of the preceding claims, wherein the heat treatment step is carried out under conditions that enable at least one portion of the carbon to be removed, until a porous layer is obtained wherein the carbon content is less than 15 at%, preferably less than 10 at% and preferably less than 5 at%.

9. The process as claimed in one of the preceding claims, wherein use is made, as the element, of silicon or of a mixture of elements predominantly including silicon, the heat treatment being carried out under conditions that enable at least one portion of the carbon and of the hydrogen to be removed, until a porous layer having a refractive index of less than 1.42, preferably of less than 1.40, or even of less than 1.35 is obtained.

10. The process as claimed in claim 9, wherein the precursor or precursors are chosen from organometallic compounds of silicon, in particular selected from siloxanes, for example hexamethyldisiloxane (HMDSO), or TDMSO (tetramethyldisiloxane), alkylsilanes, for example diethoxymethylsilane (DEMS), (Si(CH₃)₃)₂ (HMDS), Si(CH₃)₄ (TMS) , (SiO(CH₃)₂)₄, (SiH(CH₃)₂)₂, silicon alcoholates, for example Si(OC₂H₅)₄ (TEOS), Si(OCH₃)₄ (TMOS), or else silicon hydrides, in particular SiH₄ or Si₂H₆, or silicon chlorides, in particular SiCl₄, CH₃SiCl₃, (CH₃)₂SiCl₂.

11. The process as claimed in one of claims 1 to 8, wherein use is made, as the element, of titanium or of a mixture of elements predominantly including titanium.

12. The process as claimed in claim 11, wherein the heat treatment is carried out under conditions that enable at least one portion of the carbon and of the hydrogen to be removed, until a porous layer having a refractive index of less than 2.30, preferably of less than 2.20, is obtained.

13. The process as claimed in either of claims 11 and 12, wherein the precursor or precursors of titanium are chosen from organometallic compounds of titanium or titanium alkyl compounds and/or titanium alcoholates, in particular Ti tetraisopropylate, diisopropoxy-titanium bis(acetylacetonate) and titanium tetraoctylene glycolate, titanium acetylacetonate, titanium methylacetoacetate and titanium ethylaceto-acetate.

14. A glazing comprising a coating consisting of at least one layer of a porous material capable of being obtained by one of claims 1 to 13.

15. A glazing comprising a coating consisting of at least one layer of a porous material essentially consisting of silicon, oxygen and optionally residual carbon and hydrogen, having a refractive index of less than 1.40, capable of being obtained by a process as claimed in one of claims 9 to 10.

16. A glazing comprising a coating consisting of at least one layer of a porous material essentially consisting of titanium, oxygen and optionally residual carbon and hydrogen, capable of being obtained by a process as claimed in one of claims 11 to 13.
